# EUROPEAN PATENT SPECIFICATION

(11) **EP 3 144 287 B1**
(45) Date of publication and mention of the grant of the patent: **07.08.2019**
(21) Application number: 15792229.5
(22) Date of filing: 14.04.2015
(51) Int. Cl.: C04B 35/581, H01S 5/022

(54) **ALN SINTERED COMPACT, ALN SUBSTRATE AND METHOD OF PRODUCING ALN SUBSTRATE**
ALN-SINTERKÖRPER, ALN-SUBSTRAT UND VERFAHREN ZUR HERSTELLUNG EINES ALN-SUBSTRATS
CORPS FRITTÉ EN ALN, SUBSTRAT EN ALN, ET PROCÉDÉ DE FABRICATION DE SUBSTRAT EN ALN

(30) Priority: 12.05.2014 JP 2014098505
(43) Date of publication of application: 22.03.2017
(73) Proprietor: Sumitomo Electric Industries, Ltd., Osaka-shi, Osaka 541-0041 (JP)
(72) Inventor: AWATA, Hideaki, Itami-shi, Hyogo 664-0016 (JP); YOSHIDA, Katsuhito, Itami-shi, Hyogo 664-0016 (JP); SOGABE, Koichi, Itami-shi, Hyogo 664-0016 (JP); HIROSE, Yoshiyuki, Itami-shi Hyogo 664-0016 (JP); ITOH, Yasushi, Itami-shi Hyogo 664-0016 (JP); UENISHI, Noboru, Itami-shi Hyogo 664-0016 (JP); KONDO,Yuka, Itami-shi Hyogo 664-0016 (JP); ISHIDU, Sadamu, Itami-shi Hyogo 664-0016 (JP); YAMAMOTO, Takehisa, Toyama-shi, Toyama 931-8543 (JP)
(74) Representative: Boult Wade Tennant LLP
(86) International application number: PCT/JP2015/061415
(87) International publication number: WO 2015/174186

(56) References cited:
- EP-A1- 0 620 203
- EP-A1- 1 078 902
- EP-A2- 1 117 273
- WO-A1-2013/008697
- JP-A- H11 278 941
- JP-A- H11 322 432

## Description

### TECHNICAL FIELD

The present invention relates to an AlN sintered compact, an AlN substrate and a method of producing an AlN substrate.

### BACKGROUND ART

An AlN substrate composed of an aluminum nitride (AlN) sintered compact has a significantly high thermal conductivity, and accordingly, it is utilized as a substrate to mount thereon a semiconductor device required to provide heat dissipation in particular (e.g., a light emitting device such as a semiconductor laser). For example, Japanese Patent Laying-Open No. 2001-348275 (patent document 1) discloses an AlN substrate for mounting a laser diode thereon.

WO2013/008697 A1 discloses an aluminum-nitride substrate comprising aluminum-nitride sintered compact containing element (2A) and element (3A). The surface roughness (Ra) of the bonding surface is 15 nm or less.

### CITATION LIST

### PATENT DOCUMENT

Patent document 1: Japanese Patent Laying-Open No. 2001-348275

### SUMMARY OF INVENTION

### TECHNICAL PROBLEM

When using an AlN substrate as a substrate to mount a light emitting device thereon, it is important how smooth the substrate's surface is, since large surface roughness results in large thermal contact resistance and the light emitting device mounted on the substrate is impaired in reliability. More specifically, the heat which the light emitting device generates cannot be efficiently transferred to the AlN substrate, heat radiation is insufficient, and the light emitting device cannot stably oscillate and emit light.

Conventionally a variety of proposals have been made in order to reduce an AlN substrate's surface roughness. For example, patent document 1 describes that in an AlN sintered compact sintered using yttria (Y₂O₃) as a sintering additive, the number of AlN crystal grains per unit area and the length of a grain boundary which surrounds them are defined to implement an AlN substrate having a surface roughness Ra of 0.05 µm or less.

However, in recent years, as light emitting devices provide high outputs, a technique which can further efficiently transfer heat from a light emitting device to an AlN substrate, that is, further reduction of surface roughness, is demanded. Accordingly, the present inventors polished an AlN sintered compact sintered using yttria as a sintering additive to attempt to reduce its surface roughness, it has been found that such a sintered compact has some limit in surface roughness and it is difficult to provide efficient heat transfer beyond the status-quo.

In view of the above problem, an object of the disclosure is to provide an AlN sintered compact with small surface roughness and an AlN substrate which allows excellently efficient heat transfer.

### SOLUTION TO PROBLEM

An AlN sintered compact according to one aspect of the present invention includes AlN crystal grains and a grain boundary phase, and the grain boundary phase is lower in Vickers hardness than the AlN crystal grains.

An AlN substrate production method according to one aspect of the present invention includes the steps of: mixing AlN powder and a sintering additive including Yb₂O₃ powder and Nd₂O₃ powder to obtain a mixture; compacting the mixture to obtain a compact; subjecting the compact to a heat treatment to obtain an AlN sintered compact; and polishing a surface of the AlN sintered compact to obtain a main surface having a surface roughness Ra of 0.015 µm or less, in the step of mixing, the mixture having a solid content such that, of the solid content, the Yb₂O₃ powder and the Nd₂O₃ powder in total occupy a proportion equal to or greater than 1 mass% and equal to or less than 5 mass%.

### ADVANTAGEOUS EFFECT OF INVENTION

According to the above, an AlN sintered compact with small surface roughness and an AlN substrate which allows excellently efficient heat transfer can be provided.

### BRIEF DESCRIPTION OF DRAWINGS

Fig. 1 is an XRD chart which shows an example of a diffraction pattern of an AlN sintered compact according to one aspect of the present invention.
Fig. 2 is a schematic diagram showing an example of a configuration of an AlN substrate according to one aspect of the present invention.
Fig. 3 is a flowchart which outlines a method of producing an AlN substrate according to one aspect of the present invention.

### DESCRIPTION OF EMBODIMENTS

### [Description of Embodiment of the Present Invention]

Initially, embodiments of the present invention will be enumerated and described.
[1] An AlN sintered compact according to one aspect of the present invention includes AlN crystal grains and a grain boundary phase, and the grain boundary phase is lower in Vickers hardness than the AlN crystal grains.
   In polishing an AlN sintered compact, there is a limit in surface roughness, which is attributed to the hardness of a grain boundary phase included in the sintered compact's structure. More specifically, it is believed that the grain boundary phase is harder than AlN crystal grains which occupy a major portion of the sintered compact's structure and is relatively hard to polish, and accordingly, on a polished surface the grain boundary phase remains in a projecting state and a smooth surface cannot be obtained. Accordingly, as described above, the grain boundary phase's Vickers hardness is restricted to be lower than the AlN crystal grain's Vickers hardness. This can prevent a polished surface form having a projecting grain boundary phase and reduce surface roughness.
   Herein, in the AlN sintered compact, the "Vickers hardness" of the AlN crystal grain and that of the grain boundary phase can be measured for example with a micro Vickers hardness meter.
[2] The grain boundary phase consists of a Yb₂O₃ crystal phase and an AlNdO₃ crystal phase.
   Generally, an AlN sintered compact is produced by compacting a mixture including AlN powder, a sintering additive, etc. into a prescribed form, and sintering the mixture. The sintered compact thus obtained will have a grain boundary phase containing a component derived from the sintering additive. When yttria (Y₂O₃) is used as a sintering additive, the grain boundary phase will be composed of a Y₄Al₂O₉ crystal phase, a YAlO₃ crystal phase, etc., and would have Vickers hardness exceeding the AlN crystal grain's Vickers hardness.
   On the other hand, when ytterbium oxide (Yb₂O₃) and neodymium oxide (Nd₂O₃) are used as a sintering additive, the grain boundary phase includes a Yb₂O₃ crystal phase and an AlNdO₃ crystal phase, and its Vickers hardness is easily lower than the AlN crystal grain's Vickers hardness. Accordingly, by the grain boundary phase including the Yb₂O₃ crystal phase and the AlNdO₃ crystal phase, further improved surface roughness can be achieved.
   Note that what type of crystal phase is included in the grain boundary phase can be identified by subjecting the AlN sintered compact to X-ray diffraction (XRD).
[3] The grain boundary phase includes Yb and Nd, and preferably a proportion of a total of Yb and Nd to the AlN sintered compact is equal to or greater than 0.87 mass% and equal to or less than 4.35 mass%, since such a grain boundary phase has a low Vickers hardness.
[4] The AlN sintered compact according to one aspect of the present invention includes the AlN sintered compact of any one of items [1] to [3] above and, at a surface of the AlN sintered compact, has a main surface having a surface roughness Ra of 0.015 µm or less.
   The AlN sintered compact of any one of items [1] to [3] above has a grain boundary phase larger in hardness than the AlN crystal grain and can be polished to have surface roughness Ra of 0.015 µm or less. And the AlN substrate having surface roughness Ra of 0.015 µm or less has a low thermal contact resistance and excellently efficiently transfers heat.
   Herein "surface roughness Ra" indicates "arithmetic mean roughness Ra" defined by "JIS B0601:2013" for the sake of illustration.
[5] Preferably, the AlN substrate has a thermal conductivity equal to or greater than 150 W/(m • K), since this can rapidly remove heat from a light emitting device and thus enhance the light emitting device in reliability.
[6] A method of producing an AlN substrate according to one aspect of the present invention includes the steps of: mixing AlN powder and a sintering additive including Yb₂O₃ powder and Nd₂O₃ powder to obtain a mixture; compacting the mixture to obtain a compact; and subjecting the compact to a heat treatment to obtain an AlN sintered compact; and polishing a surface of the AlN sintered compact to obtain a main surface having a surface roughness Ra of 0.015 µm or less, in the step of mixing, the mixture having a solid content such that, of the solid content, the Yb₂O₃ powder and the Nd₂O₃ powder in total occupy a proportion equal to or greater than 1 mass% and equal to or less than 5 mass%.

According to the production method, an AlN substrate having surface roughness Ra of 0.015 µm or less can be easily produced.

### [Detailed Description of Embodiments of the Present Invention]

The present invention will now be described in embodiments (hereinafter also referred to as "the present embodiment") hereinafter in detail, however, the present embodiments are not limited thereto.

### <First Embodiment: AlN Sintered Compact>

A first embodiment is an AlN sintered compact. The AlN sintered compact of the present embodiment includes AlN crystal grains as a major component, and, furthermore, includes a grain boundary phase as a balance.

### (Vickers Hardness)

The AlN sintered compact of the present embodiment has the grain boundary phase lower in Vickers hardness than the AlN crystal grains. This can prevent the grain boundary phase from projecting on a polished surface of the AlN sintered compact. That is, surface roughness Ra can be reduced.

The Vickers hardness of the AlN crystal grain and that of the grain boundary phase can be measured using a micro Vickers hardness meter. The micro Vickers hardness meter is a measurement instrument such that while a sample is observed under a microscope, an indenter can be pushed into a microscopic site within an observation field of view to measure the microscopic site's Vickers hardness. One such micro Vickers hardness meter is a micro Vickers hardness testing machine (model "HM-124", manufactured by "Mitutoyo Corp.") etc., for example.

A measuring load of 1 gf is set in the present embodiment. And the AlN sintered compact is observed under a microscope, an AlN crystal grain or a grain boundary phase is selected, the indenter is pushed in, and Vickers hardness (HV) is calculated from a surface area of an indentation. Desirably, in order to increase measurement accuracy, measurement is performed more than once (for example, about 5 times) for each of the AlN crystal grain and the grain boundary phase, and the Vickers hardness of the AlN crystal grain and that of the grain boundary phase are each determined from an average value of a plurality of measurements.

The Vickers hardness of the AlN crystal grain and that of the grain boundary phase are controllable by a sintering condition, the sintering additive's composition, etc. The Vickers hardness of the AlN crystal grain is about HV 500-600, for example. Furthermore, the Vickers hardness of the grain boundary phase is for example about HV 250-500, preferably about HV 250-400, more preferably about HV 250-300.

### (AlN Crystal Grain)

AlN crystal grains comprise a major portion of the sintered compact's structure (generally equal to or greater than 90 volume%). The volume content of the AlN crystal grains in the AlN sintered compact is preferably equal to or greater than 93 volume% and equal to or less than 99.5 volume%, more preferably equal to or greater than 95 volume% and equal to or less than 99.5 volume%, particularly preferably equal to or greater than 96 volume% and equal to or less than 99.5 volume%, since when the volume content of the AlN crystal grains occupies the above range, high thermal conductivity is obtained.

The volume content of the AlN crystal grains in the AlN sintered compact can be measured for example by the following method. Initially, a surface of the AlN sintered compact is mirror-polished and a backscattered electron image of the polished surface is obtained using a scanning electron microscope (SEM). At the time, desirably, the observation magnification is about 1000-3000 times for example, and adjusted to allow about 150 AlN crystal grains to be in an observation field of view. Then, the backscattered electron image (an image in the observation field of view) is binarized and an area occupied by the AlN crystal grains in the image in the observation field of view is measured. And by dividing the AlN crystal grains' occupied area by the area of the AlN sintered compact in the image in the observation field of view, the volume content of the AlN crystal grains can be obtained.

Furthermore, from a point of view of the sintered compact's strength, the AlN crystal grain has a grain size for example of about 1-10 µm, preferably about 1-5 µm. Note that the grain size is obtained as follows: in the backscattered electron image of the structure of the sintered compact obtained in the above volume content measurement, a diameter of a circle circumscribing an AlN crystal grain (i.e., a circumscribed circle diameter) is measured and regarded as the grain size.

### (Grain Boundary Phase)

The grain boundary phase is formed between an AlN crystal grain and an AlN crystal grain. The grain boundary phase normally comprises a component derived from a sintering additive. As the sintering additive, Yb₂O₃, Nd₂O₃, Al₂O₃, Y₂O₃, etc. can be indicated as an example.

The grain boundary phase consists of a Yb₂O₃ crystal phase and an AlNdO₃ crystal phase, since a grain boundary phase which includes both of these two crystal phases easily have low Vickers hardness. A component derived from Y₂O₃ is not included. As a component derived from Y₂O₃, there are a Y₄Al₂O₉ crystal phase, a YAlO₃ crystal phase, etc., for example, since a grain boundary phase including these components easily has high Vickers hardness and a smooth polished surface cannot be obtained.

What crystal phase is included in the grain boundary phase can be identified by an XRD method. More specifically, a crystal phase can be identified by measuring the AlN sintered compact's XRD pattern (diffraction peak's position and intensity) and comparing it with an XRD pattern of a compound described on a JCPDS (Joint Committee on Powder Diffraction StandardS) card. Note that assistively, an elemental mapping by an Electron ProbeMicro Analyzer (EPMA) may be used together to confirm that each crystal phase component is detected in the grain boundary phase.

### (Total Content of Yb and Nd)

Preferably, a proportion of a total of Yb and Nd to the AlN sintered compact is equal to or greater than 0.87 mass% and equal to or less than 4.35 mass%, since a grain boundary phase which has such a composition is easily polished and surface roughness Ra can be reduced. Note that the content of each element can be measured by the Inductively Coupled Plasma-Mass Spectrometry (ICP-MS). The proportion of a total of Yb and Nd to the AlN sintered compact is more preferably equal to or greater than 1.21 mass% and equal to or less than 4.35 mass%, and particularly preferably equal to or greater than 1.21 mass% and equal to or less than 2.00 mass%, since this allows surface roughness Ra to be further reduced.

Furthermore, from a similar point of view, in the AlN sintered compact, the mass ratio of Yb and Nd is for example Yb:Nd = about 1:(0.75-0.79) and is preferably Yb:Nd = about 1: (0.75-0.77).

### (Density of AlN Sintered Compact)

The density of the AlN sintered compact can be measured by the Archimedes method. More specifically, from the mass of a sample (the AlN sintered compact) a mass when the sample is immersed in water is deducted to obtain the sample's volume, and the sample's mass is divided by the volume to calculate the density. The density of the AlN sintered compact is preferably equal to or greater than 3.0 g/cm³, more preferably equal to or greater than 3.2 g/cm³, and particularly preferably equal to or greater than 3.3 g/cm³, since higher density helps to manifest suitable thermal conductivity. The density of the AlN sintered compact is adjustable by the amount of a sintering additive added, the sintering temperature and the like for example.

### <Second Embodiment: AlN Substrate >

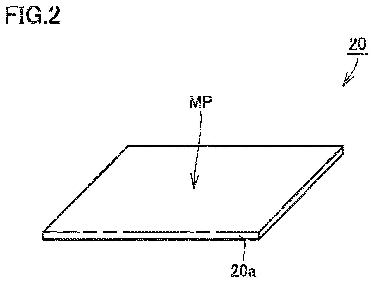

A second embodiment is an AlN substrate. With reference to Fig. 2, the second embodiment provides an AlN substrate 20 including an AlN sintered compact 20a of the first embodiment, and having a main surface MP having surface roughness Ra of 0.015 µm or less. AlN substrate 20 is produced by polishing AlN sintered compact 20a of the first embodiment. Accordingly, it excellently efficiently transfers heat and it is suitable as a substrate for attaching a light emitting device. The shape of the substrate is not particularly limited and may be changed as appropriate depending on the application. For example, the shape can be rectangular or circular.

Surface roughness Ra of main surface MP is 0.015 µm or less. This allows heat generated by a light emitting device to be efficiently transferred to AlN substrate 20 and can thus enhance the light emitting device's reliability. Surface roughness Ra can be measured with a general surface roughness meter. The surface roughness meter may be a contact type or may be a contactless type (an optical type). Surface roughness Ra is more preferably 0.012 µm or less, and particularly preferably 0.010 µm or less. Surface roughness Ra having a smaller value is more preferable, and ideally, it is zero, however, when productivity is considered, it is preferably 0.0005 µm or more.

### (Thermal Conductivity)

The thermal conductivity of AlN substrate 20 is measured in a laser flash method in conformity with "JIS R1611:2010." The laser flash method is a method such that a surface of a planar sample (for example, an AlN substrate) held at a constant temperature is irradiated with pulsed laser and thus heated instantaneously, and how the sample's back surface varies in temperature over time is measured to measure thermal diffusivity. And thermal conductivity is calculable by multiplying the obtained thermal diffusivity by the sample's specific heat and density.

Preferably, AlN substrate 20 has thermal conductivity equal to or greater than 150 W/(m • K), since this allows heat transferred from a light emitting device to be rapidly removed. It is preferable that AlN substrate 20 have higher thermal conductivity. Accordingly, the thermal conductivity of AlN substrate 20 is more preferably equal to or greater than 160 W/(m • K), and particularly preferably equal to or greater than 170 W/(m • K). The upper limit value of the thermal conductivity is not particularly limited, however, when productivity is taken into consideration, the thermal conductivity is preferably equal to or less than 285 W/(m • K).

### <Third Embodiment: AlN Substrate Production Method >

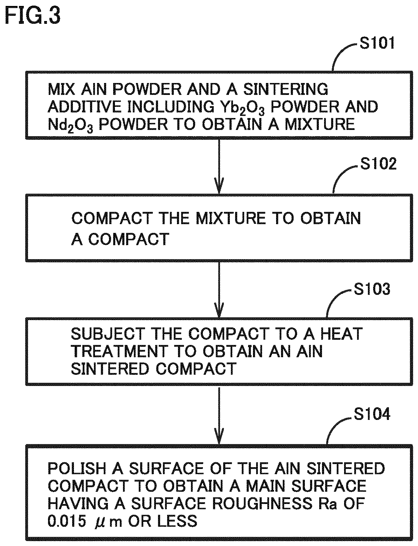

An AlN substrate of the present embodiment can be produced in a method described hereinafter. Fig. 3 is a flowchart which outlines an AlN substrate production method according to the present embodiment. As indicated in Fig. 3, the production method of the present embodiment includes step S101, step S102, step S103, and step S104, and initially the AlN sintered compact of the first embodiment is produced (step S101 to step S103), and furthermore, the AlN sintered compact is polished to produce the AlN substrate (step S104). Hereinafter, each step will be described.

### (Step S101)

At step S101, AlN powder and a sintering additive consisting of Al₂O₃ powder, Yb₂O₃ powder and Nd₂O₃ powder are mixed together to obtain a mixture.

At step S101, as long as AlN powder and the sintering additive consisting of Al₂O₃ powder, Yb₂O₃ powder and Nd₂O₃ powder are used, any other component may be added. As any component, a binder and a solvent as described later, and other than them, a dispersant, a plasticizer, a mold releasing agent, etc. can be indicated as an example.

The mixing device can be a ball mill, an attritor, etc. The mixing may be dry mixing or wet mixing, however, when dispersibility is taken into consideration, wet mixing is preferable. In the wet mixing, any solvent may be used. For example, an organic solvent such as ethanol, isopropyl alcohol and butanol can be used. The mixing time is about 1-12 hours in general.

### (AlN Powder)

From a point of view of the density of the sintered compact, the AlN powder preferably has an average particle size of about 0.1-5 µm, more preferably about 0.1-3 µm. Note that the average particle size indicates a value measured by a laser diffraction scattering method for the sake of illustration.

### (Sintering Additive)

In the present embodiment, Yb₂O₃ powder and Nd₂O₃ powder are used as a sintering additive, since by using these materials, a grain boundary phase of a low Vickers hardness is obtained. From a point of view of dispersibility, Yb₂O₃ powder and Nd₂O₃ powder preferably has an average particle size of about 0.1-5 µm, more preferably about 0.1-3 µm. Note that as the sintering additive, other than these, Al₂O₃ powder etc. may for example be used.

Yb₂O₃ powder and Nd₂O₃ powder are used in an amount set such that Yb₂O₃ powder and Nd₂O₃ powder in total occupy the mixture's solid content by 1 mass% or more and 5 mass% or less, since thereby a grain boundary phase including a Yb₂O₃ crystal phase and an AlNdO₃ crystal phase is formed. Note that Yb₂O₃ powder and Nd₂O₃ powder in total occupy the mixture's solid content preferably by 1.4 mass% or more and 5 mass% or less, particularly preferably by 1.4 mass% or more and 2.3 mass% or less to further ensure that a grain boundary phase including the Yb₂O₃ crystal phase and the AlNdO₃ crystal phase is formed.

Furthermore, from a similar point of view, Yb₂O₃ powder and Nd₂O₃ powder are used in amounts, respectively, at a ratio (a mass ratio) for example of Yb₂O₃ powder:Nd₂O₃ powder = about 1:(0.75-0.79), preferably Yb₂O₃ powder:Nd₂O₃ powder = about 1:(0.75-0.77).

### (Binder)

The binder is not limited to any particular binder and a conventionally known material can be used. For example, binders such as an acrylic binder, a polyvinyl alcohol (PVA) based binder, a polyvinyl butyral based binder, a cellulose based binder, etc. can be used. Two or more types of binders may be used together.

### (Step S102)

At step 102, the mixture (a slurry) is compacted to obtain a compact (a so-called "green sheet"). This may be done in any method, and for example, the compact can be obtained from the slurry by extrusion molding, injection molding, and tape casting (using a doctor blade etc.). The obtained compact may be air-dried or dried with hot air using a spray dryer etc.

### (Step S103)

At step S103, the compact undergoes a heat treatment to provide an AlN sintered compact. Step S103 normally includes a degreasing step and a sintering step.

In the degreasing step, a heat treatment is performed to remove an organic component of the binder etc. The heat treatment's temperature is about 500-900°C for example although it depends on the type of the binder used. The heat treatment's time is about 5-15 hours for example. The heat treatment's atmosphere is preferably a non-oxidizing atmosphere such as argon and nitrogen from a point of view to prevent oxygen from remaining.

In the sintering step, the degreased compact is sintered at 1780°C or more and 1900°C or less, since when the sintering temperature is less than 1780°C, insufficient sintering is provided and a dense sintered compact may not be obtained, which is unpreferable. When the sintering temperature exceeds 1900°C coarse AlN crystal grains may be provided and the sintered compact's toughness etc. may be decreased, which is unpreferable. The sintering temperature is more preferably 1780°C or more 1850°C or less. The sintering may be done under the atmospheric pressure or while pressurized. Pressure applied when the sintering is done while pressurized is less than 10 atmospheres in general.

### (Step S104)

At step S104, a surface of AlN sintered compact 20a is polished to obtain main surface MP having surface roughness Ra of 0.015 µm or less. The polishing may be done in any method and for example it can be done by mechanical polishing using a loose abrasive or a bonded abrasive, chemical mechanical polishing using a polishing liquid, or the like. As has been previously discussed, the AlN sintered compact of the present embodiment has a grain boundary phase softer than AlN crystal grains, and by polishing, surface roughness Ra can be 0.015 µm or less.

Thus by performing step S101 to step S104, an AlN substrate having surface roughness Ra of 0.015 µm or less and excellently efficiently transferring heat can be produced.

### Examples

Hereinafter, although the present embodiment will more specifically be described using examples, the present embodiment is not limited to these examples.

### <Producing AlN Sintered Compact>

Sintered compacts No. 1A to No. 8A were produced under production conditions No. 1 to No. 8.

### 1. Mixing Source Materials

AlN powder was prepared. Yb₂O₃ powder, Nd₂O₃ powder, Al₂O₃ powder and Y₂O₃ powder as a sintering additive, and an acrylic binder and a PVA based binder were prepared.

The above source materials were blended as a binder (17 mass%), a sintering additive (components and amounts blended as indicated in table 1), and AlN powder (a balance), and furthermore, a solvent (ethanol) was added, and the materials were mixed together for 6 hours using a ball mill (step S101). Thus a mixture (a slurry) was obtained. In table 1, production conditions No. 1 to No. 3 correspond to working examples of the production method.

**Table 1**

| production condition Nos. | AlN substrate (AlN sintered compact) production conditions | | | | | |
|---|---|---|---|---|---|---|
| | amount of sintering additive blended | | | | | sintering temperature |
| | Yb₂O₃ powder | Nd₂O₃ powder | Al₂O₃ powder | Y₂O₃ powder | total of Yb₂O₃ powder & Nd₂O₃ powder | |
| | mass% | mass% | mass% | mass% | mass% | °C |
| 1 | 1.3 | 1.0 | 0.9 | 0 | 2.3 | 1780 |
| 2 | 0.8 | 0.6 | 0.6 | 0 | 1.4 | 1850 |
| 3 | 2.8 | 2.2 | 1.8 | 0 | 5.0 | 1900 |
| 4 | 0.5 | 0.4 | 0.4 | 0 | 0.9 | 1880 |
| 5 | 3.5 | 3.0 | 2.7 | 0 | 6.5 | 1850 |
| 6 | 2.0 | 0 | 0.6 | 0 | 2.0 | 1850 |
| 7 | 0 | 2.5 | 1.8 | 0 | 2.5 | 1880 |
| 8 | 0 | 0 | 0 | 5 | 0 | 1850 |

### 2. Compacting

The slurry was supplied to an extruder. Inside the extruder, the slurry was kneaded and vacuum-degassed, and compressed and extruded through a die to provide a sheet-like compact (of 1.0 mm in thickness) (step S102).

### 3. Degreasing and Sintering

After the compact was air-dried, the compact underwent a heat treatment in an nitrogen atmosphere at a temperature of 700°C for 10 hours to remove an organic component. A degreased product is thus obtained.

Then, the degreased product was disposed on a jig made of boron nitride (BN), and, together with the jig, disposed in a carbon furnace. And the degreased product underwent a heat treatment in a nitrogen atmosphere at sintering temperatures indicated in table 1 for 15 hours to obtain sintered compacts No. 1A to No. 8A (step S103). Sintered compacts No. 1A to No. 8A correspond to production conditions No. 1 to No. 8, respectively.

### <Assessing AlN Sintered Compact>

### 4. Measuring Density

The AlN sintered compact's density was measured by the Archimedes method, as has been set forth above. The result is shown in table 2. In table 2, sintered compacts No. 1A to No. 5A correspond to working examples of the AlN sintered compact.

**Table 2**

| sintered compact Nos. | AlN sintered compact | | | | | | | |
|---|---|---|---|---|---|---|---|---|
| | density | crystal phase detected via XRD | element content | | | Vickers hardness (HV) | | surface rough-ness Ra |
| | | | Yb | Nd | total of Yb & Nd | AlN crystal grain | grain boundary phase | |
| | g/cm³ | | mass % | mass % | mass% | | | µm |
| 1A | 3.30 | Yb₂O₃ crystal phase | 1.14 | 0.86 | 2.00 | 574 | 273 | 0.010 |
| | | AlNdO₃ crystal phase | | | | | | |
| 2A | 3.20 | Yb₂O₃ crystal phase | 0.70 | 0.51 | 1.21 | 540 | 280 | 0.010 |
| | | AlNdO₃ crystal phase | | | | | | |
| 3A | 3.33 | Yb₂O₃ crystal phase | 2.46 | 1.89 | 4.35 | 605 | 276 | 0.012 |
| | | AlNdO₃ crystal phase | | | | | | |
| 4A | 2.50 | Yb₂O₃ crystal phase | 0.44 | 0.34 | 0.78 | 581 | 282 | 1.0 |
| | | AlNdO₃ crystal phase | | | | | | |
| 5A | 3.38 | Yb₂O₃ crystal phase | 3.07 | 2.57 | 5.64 | 557 | 282 | 0.030 |
| | | AlNdO₃ crystal phase | | | | | | |
| 6A | 2.50 | Yb₂O₃ crystal phase | 1.76 | 0 | 1.76 | 591 | 656 | 1.6 |
| 7A | 3.32 | AlNdO₃ crystal phase | 0 | 2.15 | 2.15 | 591 | 713 | 0.040 |
| 8A | 3.34 | Y₄Al₂O₉ crystal phase | 0 | 0 | 0 | 541 | 824 | 0.027 |
| | | YAlO₃ crystal phase | | | | | | |

### 5. X-ray Diffraction Measurement

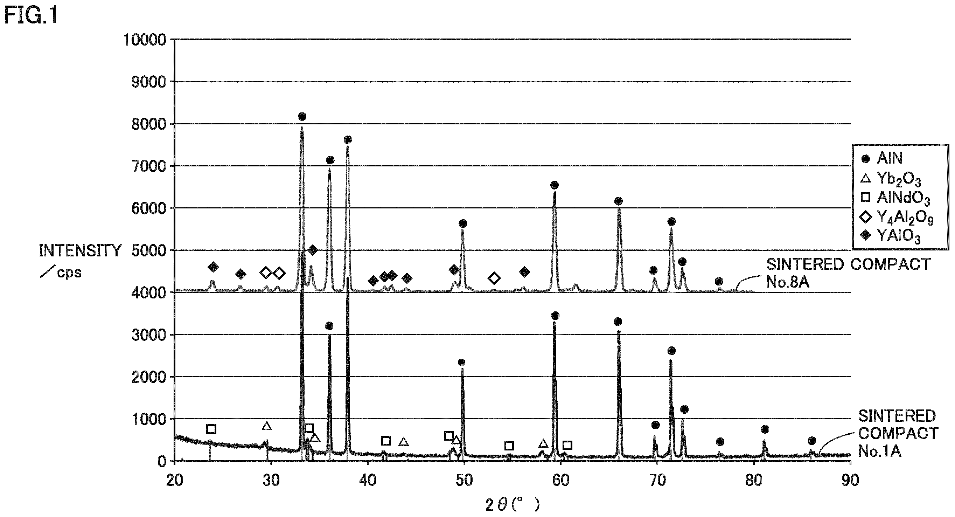

The AlN sintered compact's crystal analysis was conducted using an X-ray diffractometer. The characteristic X-ray was a CuKα ray, and an angle of diffraction 2θ and diffraction intensity were measured. And the XRD pattern was compared with JCPD card data to identify a crystal phase included in a grain boundary phase. The XRD patterns of sintered compacts No. 1A and No. 8A are indicated in Fig. 1. As shown in Fig. 1, in sintered compact No. 1A using Yb₂O₃ and Nd₂O₃ as a sintering additive, a peak derived from a Yb₂O₃ crystal phase and an AlNdO₃ crystal phase was observed. On the other hand, in sintered compact No. 8A using Y₂O₃ as a sintering additive, a peak derived from these crystal phases was not observed, and a peak derived from a Y₄Al₂O₉ crystal phase and a YAlO₃ crystal phase was observed. Each sintered compact's analysis result is shown in table 2.

### 6. Measuring Yb and Nd Contents

Each sintered compact's Yb and Nd contents were measured using an ICP-MS device. The result is shown in table 2.

### 7. Measuring Vickers Hardness

A micro Vickers hardness testing machine (a model "HM-124", manufactured by Mitutoyo Corp.) was used and a measuring load of 1 gf was applied to measure the Vickers hardness of an AlN crystal grain and that of a grain boundary phase in each sintered compact. The result is shown in table 2. Note that in table 2 the column "Vickers hardness" presents numerical values each indicating an average value in Vickers hardness of values obtained at five points of measurement.

### <Producing AlN substrate>

### 8. Polishing

Sintered compacts No. 1A to No. 8A each had opposite main surfaces coarsely polished using a loose abrasive and subsequently had one main surface finely polished to obtain substrates No. 1B to No. 8B in the form of a rectangle having a length of 70 mm, a width of 70 mm, and a thickness of 0.25 mm. Substrates No. 1B to No. 8B correspond to sintered compacts No. 1A to No. 8A, respectively.

### <Assessing AlN substrate>

### 9. Measuring Surface Roughness Ra

Each substrate's surface roughness Ra was measured using a contactless type surface roughness measurement device (product name "NewView" produced by "ZYGO"). The result is indicated in table 2 and table 3. In table 3, substrates No. 1B to No. 3B correspond to working examples of the AlN substrate.

**Table 3**

| substrate Nos. | AlN substrate | | |
|---|---|---|---|
| | thermal conductivity | surface roughness Ra | stability of laser oscillation |
| | W/(m · K) | µm | |
| 1B | 180 | 0.010 | A |
| 2B | 160 | 0.010 | A |
| 3B | 170 | 0.012 | A |
| 4B | 90 | 1.5 | B |
| 5B | 170 | 0.030 | B |
| 6B | 104 | 1.1 | B |
| 7B | 141 | 0.040 | B |
| 8B | 179 | 0.027 | B |

### 10. Measuring Thermal Conductivity

As has been discussed above, a laser flash method was used to each substrate's thermal conductivity. The result is shown in table 3.

### 11. Assessing stability of laser oscillation

By sputtering, a thin nickel (Ni) film was formed on a main surface of each substrate. And a laser diode (optical power: 200 mW, and oscillation wavelength: 1480 nm) was mounted thereon to produce a laser diode module.

Each laser diode module was continuously operated and a percentage of an oscillation wavelength 1 hour after oscillation started divided by an oscillation wavelength when oscillation started was presented as laser oscillation's decrement rate. And laser oscillation's stability was assessed by two levels of "A" and "B" as indicated below. The result is shown in table 3.
A: laser oscillation' decrement rate is less than 8%.
B: laser oscillation' decrement rate is 15% or more.

### <Result and Discussion>

### 1. AlN Sintered Compact

From table 2, a sintered compact in which the Vickers hardness of the grain boundary phase is lower than the Vickers hardness of the AlN crystal grain has a tendency to have surface roughness Ra having a small value after it is polished than a sintered compact which does not satisfy such a condition.

However, when the sintered compact has low density, i.e., when the sintered compact has a density less than 3.2 g/cm³, it does not have a similar tendency. This is because it has a surface roughness increased by voids caused in the sintered compact when it has low density. Accordingly, the sintered compact's density is desirably equal to or greater than 3.2g/cm³.

Furthermore, from table 2, it can be seen that a sintered compact in which the Vickers hardness of the grain boundary phase is lower than the Vickers hardness of the AlN crystal grain (i.e., No. 1A to No. 5A) has the grain boundary phase with the Yb₂O₃ crystal phase and the AlNdO₃ crystal phase both included therein. In contrast, a sintered compact in which the Vickers hardness of the grain boundary phase is higher than the Vickers hardness of the AlN crystal grain (i.e., No. 6A to No. 8A) has the grain boundary phase with a component derived from either one of the Yb₂O₃ crystal phase and the AlNdO₃ crystal phase or yttria included therein. Thus it can be said that preferably the grain boundary phase includes both the Yb₂O₃ crystal phase and the AlNdO₃ crystal phase.

Furthermore, from table 2, sintered compacts No. 1A to No. 3A containing Yb and Nd in a total amount equal to or greater than 0.87 mass% and equal to or less than 4.35 mass% allows surface roughness Ra to be reduced as compared with sintered compacts No. 4A and No. 5A which do not satisfy such a condition. Accordingly, it can be said that preferably, a proportion of a total amount of Yb and Nd to the AlN sintered compact is equal to or greater than 0.87 mass% and equal to or less than 4.35 mass%.

### 2. AlN Substrate

From table 3, it has been confirmed that laser diode modules using substrates No. 1B to No. 3B having surface roughness Ra of 0.015 µm or less present stable laser oscillation. This is because it is believed that thermal contact resistance became small as surface roughness Ra is 0.015 µm or less.

### 3. AlN Substrate Production Method

From tables 1-3, in mixing the source materials (more specifically, in step S101), production conditions No. 1 to No. 3 in which, of the mixture's solid content, Yb₂O₃ powder and Nd₂O₃ powder in total occupy a proportion equal to or greater than 1 mass% and equal to or less than 5 mass%, allowed a sintered compact in which the Vickers hardness of the grain boundary phase is lower than the Vickers hardness of the AlN crystal grain, and furthermore, by polishing the sintered compact, an AlN substrate having surface roughness Ra of 0.015 µm or less was able to be produced.

Thus while the present embodiments and examples were described, it is also initially planned to combine the configuration of each embodiment and that of each example as appropriate.

It should be understood that the embodiments and examples disclosed herein have been described for the purpose of illustration only and in a non-restrictive manner in any respect. The scope of the present invention is defined by the terms of the claims, rather than the embodiment described above, and is intended to include any modifications within the meaning and scope equivalent to the terms of the claims.

### REFERENCE SIGNS LIST

20: AlN substrate; 20a: AlN sintered compact; MP: main surface.

## Claims

1. An AlN sintered compact comprising an AlN crystal grain and a grain boundary phase,
the grain boundary phase being lower in Vickers hardness than the AlN crystal grain,
wherein the grain boundary phase consists of a Yb₂O₃ crystal phase and an AlNdO₃ crystal phase.

2. The AlN sintered compact according to claim 1, wherein:
the grain boundary phase includes Yb and Nd; and
a proportion of a total of Yb and Nd to the AlN sintered compact is equal to or greater than 0.87 mass% and equal to or less than 4.35 mass%.

3. An AlN substrate comprising the AlN sintered compact according to claim 1 or claim 2, and, at a surface of the AlN sintered compact, having a main surface having a surface roughness Ra of 0.015 µm or less.

4. The AlN substrate according to claim 3, having a thermal conductivity equal to or greater than 150 W/(m · K).

5. A method of producing an AlN substrate, the method comprising the steps of:
mixing AlN powder and a sintering additive consisting of Yb₂O₃ powder, Nd₂O₃ powder and Al₂O₃ powder to obtain a mixture;
compacting the mixture to obtain a compact;
subjecting the compact to a heat treatment to obtain an AlN sintered compact; and
polishing a surface of the AlN sintered compact to obtain a main surface having a surface roughness Ra of 0.015 µm or less,
in the step of mixing, the mixture having a solid content such that, of the solid content, the Yb₂O₃ powder and the Nd₂O₃ powder in total occupy a proportion equal to or greater than 1 mass% and equal to or less than 5 mass%.

## Patentansprüche

1. AlN Sinterkörper, der ein AlN Kristallkorn und eine Korngrenzphase umfasst,
wobei die Korngrenzphase eine geringere Vickers-Härte als das AlN Kristallkorn aufweist,
wobei die Korngrenzphase aus einer Yb₂O₃ Kristallphase und einer AlNdO₃ Kristallphase besteht.

2. AlN Sinterkörper gemäß Anspruch 1, wobei:
die Korngrenzphase Yb und Nd einschließt; und
ein Anteil des gesamten Yb und Nd zu dem AlN Sinterkörper gleich oder größer als 0,87 Massen-% und gleich oder weniger als 4,35 Massen-% beträgt.

3. AlN Substrat, das den AlN Sinterkörper gemäß Anspruch 1 oder Anspruch 2 umfasst, und, an einer Oberfläche des AlN Sinterkörpers, eine Hauptoberfläche mit einer Oberflächenrauheit Ra von 0,015 µm oder weniger aufweist.

4. AlN Substrat gemäß Anspruch 3 mit einer Wärmeleitfähigkeit gleich oder größer als 150 W/(m·K).

5. Verfahren zur Herstellung eines AlN Substrats, wobei das Verfahren die folgenden Schritte umfasst:
AlN Pulver und ein Sinterzusatzstoff, bestehend aus Yb₂O₃ Pulver, Nd₂O₃ Pulver und Al₂O₃ Pulver, werden gemischt und so eine Mischung erhalten;
die Mischung wird so verdichtet, dass ein Presskörper erhalten wird;
der Presskörper wird einer Wärmebehandlung unterzogen und so ein AlN Sinterkörper erhalten; und
eine Oberfläche des AlN Sinterkörpers wird so poliert, dass eine Hauptoberfläche, die eine Oberflächenrauheit Ra von 0,015 µm oder weniger aufweist, erhalten wird,
wobei die Mischung in dem Mischungsschritt einen solchen Feststoffgehalt aufweist, dass das Yb₂O₃ Pulver und das Nd₂O₃ Pulver insgesamt einen Anteil gleich oder größer als 1 Massen-% und gleich oder weniger als 5 Massen-% des Feststoffgehalts ausmachen.

## Revendications

1. Corps compacté fritté d'AlN comprenant un grain de cristal d'AlN et une phase de joint de grain,
la phase de joint de grain étant inférieure en dureté Vickers au grain de cristal d'AlN,
dans lequel la phase de joint de grain consiste en une phase de cristal de Yb₂O₃ et une phase de cristal d'AlNdO₃.

2. Corps compacté fritté d'AlN selon la revendication 1, dans lequel :
la phase de joint de grain inclut Yb et Nd ; et
une proportion d'un total de Yb et Nd par rapport au corps compacté fritté d'AlN est supérieure ou égale à 0,87 % en masse et inférieure ou égale à 4,35 % en masse.

3. Substrat d'AlN comprenant le corps compacté fritté d'AlN selon la revendication 1 ou la revendication 2, et, à une surface du corps compacté fritté d'AlN, présentant une surface principale présentant une rugosité de surface Ra de 0,015 µm ou inférieure.

4. Substrat d'AlN selon la revendication 3, présentant une conductivité thermique supérieure ou égale à 150 W/(m.K).

5. Procédé de production d'un substrat d'AlN, le procédé comprenant les étapes de :
mélange de poudre d'AlN et d'un additif de frittage consistant en poudre de Yb₂O₃, poudre de Nd₂O₃ et poudre d'Al₂O₃ pour obtenir un mélange ;
compactage du mélange pour obtenir un corps compacté ;
soumission du corps compacté à un traitement thermique pour obtenir un corps compacté fritté d'AIN ; et
polissage d'une surface du corps compacté fritté d'AlN pour obtenir une surface principale présentant une rugosité de surface Ra de 0,015 µm ou inférieure,
dans l'étape de mélange, le mélange présentant une teneur solide telle que, de la teneur solide, la poudre de Yb₂O₃ et la poudre de Nd₂O₃ occupent au total une proportion supérieure ou égale à 1 % en masse et inférieure ou égale à 5 % en masse.
